Europäisches Patentamt

European Patent Office

Office européen des brevets

(11) Publication number: **0 096 653**
**B1**

# EUROPEAN PATENT SPECIFICATION

(45) Date of publication of patent specification: **12.04.89**

(21) Application number: **83810209.3**

(22) Date of filing: **17.05.83**

(51) Int. Cl.⁴: **H 03 H 9/19,** H 03 H 9/13, H 03 H 9/05, G 04 F 5/06

(54) **Extensional mode piezoelectric microresonator.**

(30) Priority: **04.06.82 US 385060**

(43) Date of publication of application:
**21.12.83 Bulletin 83/51**

(45) Publication of the grant of the patent:
**12.04.89 Bulletin 89/15**

(84) Designated Contracting States:
**CH DE FR GB LI**

(56) References cited:
EP-A-0 056 783
GB-A- 848 529
GB-A-1 560 537
US-A-2 157 701
US-A-2 185 599

(73) Proprietor: **STATEK CORPARATION
512 North Main Street
Orange, CA. 92668 (US)**

(72) Inventor: **Chuang, Shih S.
3931 Ash Street
Irvine California 92714 (US)**

(74) Representative: **Pears, David Ashley et al
REDDIE & GROSE 16 Theobalds Road
London WC1X 8PL (GB)**

Courier Press, Leamington Spa, England.

## Description

The present invention relates to an extensional mode piezoelectric microresonator and, more particularly, to such a piezoelectric microresonator operating in an even harmonic or overtone mode.

The growing use of microelectronics for control of machinery, tools, appliances and toys has created a significant need for frequency control devices. Especially in the case of microprocessor-based systems, a clock signal generator of known frequency is required to synchronize system operation. While low accuracy systems can generally be controlled by ceramic resonators, more accurate frequency control devices and microprocessor-based systems require the frequency stability of a quartz resonator or other element with equal performance.

Many different types of quartz crystals having different cuts and different modes of operation are well known. Crystals cut in the form of a tuning fork are widely used in the production of oscillator circuits forming the time bases for electronic watches. However, the frequency range of tuning fork type crystals is in the low kHz range. It is possible to use overtone modes of tuning fork designs to obtain rugged and low cost crystals that are well suited for applications up to frequencies of several hundred kHz. However, microprocessor-based systems today require operation in the low MHz range.

AT-cut crystals are extremely desirable above 4 MHz. Even though it is possible to manufacture AT-cut crystals in the low MHz range, these units become bulky. Thus, production of a microresonator using an AT-cut crystal in the low MHz range is expensive and their electrical and mechanical parameters, especially the quality factor Q, are considerably inferior to the parameters of AT-cut resonators above 4 MHz.

The frequency region between several hundred kHz and a few MHz is the domain of the torsion-bar, face-shear and extensional mode resonators. Torsion bar resonators suffer from a low piezoelectric coupling and face shear devices require expensive mounting techniques that are often shock-sensitive, due to the necessity of clamping the resonators in the nodal axis which goes through the center of the plate. Thus, the most desirable quartz crystal in this frequency range is one operating in the extensional mode.

Piezoelectric microresonators operating in the extensional mode are well known. They typically comprise a substantially parallelepipedal bar having a length, width and thickness forming four sides and two ends and electrodes which are disposed on the bar. The electrodes are connected to an alternating current source and produce electric fields in the piezoelectric material, the directions of which are fixed by the position of the electrodes. Application of an electric field along the electrical or X-axis produces stresses in the crystal along the mechanical or Y-axis so that the bar vibrates. The vibration consists simply of a displacement in the direction of the length of the bar of a wave propagated along the length. This means that the first mode of vibration will be simply an expansion and contraction of all points with respect to the center of the bar. This motion will be along the length. The displacements along the bar will then be in proportion to the sine of the angular distance from the center. Since the motion must be dynamically balanced, a node will appear at the center of the bar and the bar will grow longer and shorter. Extensional mode piezoelectric microresonators are further disclosed in US—A—4,216,402 and US—A—4,139,793 and GB—A—1,560,537.

The fundamental frequency $f_o$ (kHz) of a quartz crystal is given by the formula

$$f_o = \frac{2750}{L}$$

where L is the length of the bar in millimeters (mm). Therefore, it would seem that it would be a simple matter to cover the frequency range between several hundred kHz and a few MHz by simply adjusting the length of the bar and operating it in its fundamental mode. This is simply achieved by providing the bar with a single pair of parallel, opposed electrodes extending for the length of the bar. However, this is not the case. These crystals are typically used in the production of oscillator circuits forming the time or frequency bases for microprocessors, portable radios, pagers and electronic watches where size is of importance. At 500 kHz, the length of the bar would be approximately 5.5 mm and this is too large. As the frequency extends above 1 MHz, the dimensions of the beam become too small, creating a significant sensitivity to any imbalances in the beam.

Still further, it is desirable that such a piezoelectric microresonator have as high a motional capacitance as possible since this minimizes problems associated with imbalances in the bar. In order to increase the motional capacitance, the width or thickness faces of the beam on which electrodes are deposited have to increase and in certain cases this may not be desirable from a manufacturing or width- or thickness-to-length ratio standpoint.

In view of the above, it has been suggested that in order for such resonators to be operated at higher frequencies while retaining bars of machinable length, use should be made of the "overtone" or "harmonic" modes. That is, a bar is theoretically capable of oscillating not only in the fundamental mode, but in harmonics of the fundamental mode. In the case of the second order of motion, the bar consists essentially of two fundamental modes joined together at their ends and of opposite phase. That is to say, when one half of the bar is expanding, the other half is contracting. In the case of the third order of motion, the central element is contracting while the external elements are expanding. From this we may state generally that for odd order types of motion, the extreme ends of the bar will be expanding or contracting in phase and for even order modes, the extreme ends will be expanding or contracting in opposite phase. We can also state that for odd order types of motion, there is a nodal line at the longitudinal centerline of the bar, and that for even order modes, there will be no nodal line at the longitudinal center of the bar.

Virtually all prior extensional mode piezoelectric microresonators have operated in the fundamental mode since this mode permits the bar to be supported by a pair of arms connected approximately to the center of the bar. In addition, US—A—4,139,793 suggests that the suspension arms be displaced slightly on opposite sides of the centerline because of the fact that vibration results from the superposition of a principal extensional mode of oscillation, of a first shear-coupled mode of oscillation, and of a second extensional-coupled mode of oscillation. It has recently been suggested that with a similar mounting, a pair of electrodes may be centrally disposed on opposite sides of the bar and additional pairs of electrodes can be placed on the bar, along the length thereof, to form an odd number n of pairs of electrodes to produce a frequency $f=nf_o$ where $f_o$ is the frequency of the bar provided with a single pair of electrodes and n is an odd integer. In this manner, odd multples of the fundamental frequency can be achieved without changing the length of the bar.

This solution has been found to be limiting because of size requirements and the frequencies desired in the marketplace. Often, for a particular frequency, the length of the bar is too small when operating at three, five or other odd multiple of the fundamental mode. No satisfactory solution to this problem has been known heretofore.

Operation in an even number overtone mode, permits one to cover certain frequency ranges where the fundamental mode, or odd number overtone modes, may not be desirable. This permits selection of the most desirable width- or thickness-to-length ratios.

US—A—2 157 701 discloses an even overtone resonator (not a microresonator) with two pairs of electrodes. The resonator is clamped at the centre of each electrode between two pairs of arms (four arms in all), whereby the resonator is fixed at two of its nodes, and any misalignment of the clamping points can lead to internal stresses which result in energy loss.

With a view to overcoming this problem the present invention provides a piezoelectric resonator as defined in claim 1.

Still other objects, features, and attendant advantages of the present invention will become apparent to those skilled in the art from a reading of the following detailed description of the preferred embodiments constructed in accordance therewith, taken in conjunction with the accompanying drawings wherein like numerals designate like or corresponding parts in the several figures and wherein:

Figure 1 is a perspective view of a first embodiment of resonator constructed in accordance with the teachings of the present invention, with the resonator being mounted in a suspension assembly;

Figure 2 is an enlarged sectional view taken along the line 2—2 of Figure 1;

Figure 3 is a simplified perspective view of an alternate electrode arrangement of the resonator of Figure 1; and

Figure 4 is a simplified perspective view of another embodiment of the present invention for producing a frequency of operation which is four times the fundamental frequency.

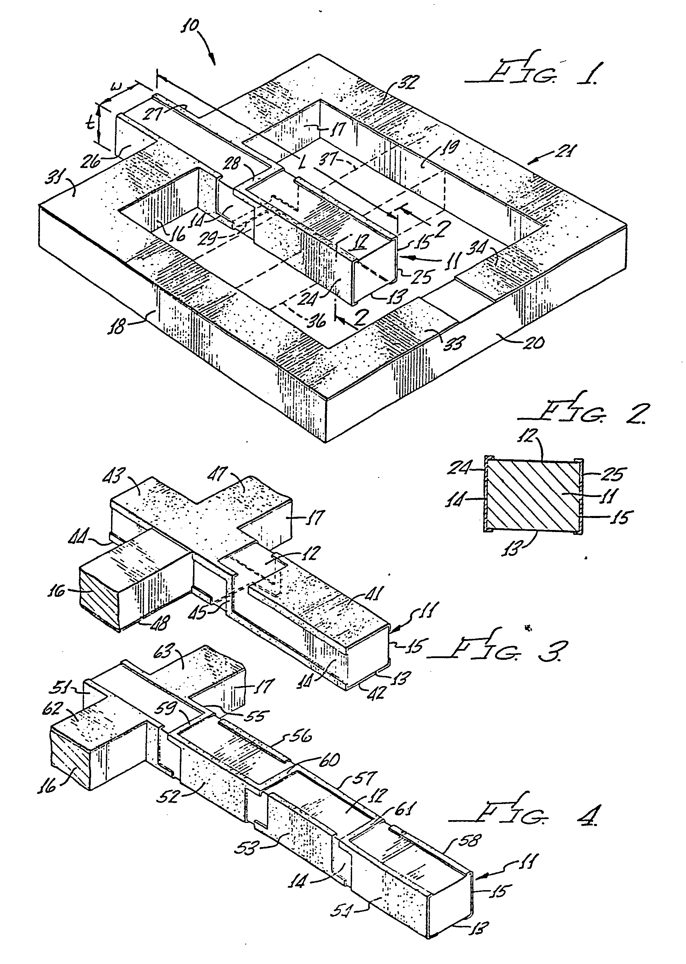

Referring now to the drawings and, more particularly, to Figures 1 and 2 thereof, there is shown a piezoelectric microresonator, generally designated 10, operating in the extensional mode. Such a microresonator includes a substantially parallelepipedal bar 11 having a length L, a width w, and a thickness t, forming four sides 12, 13, 14 and 15, and two ends. Bar 11 is made from quartz or any other suitable piezoelectric material. Microresonator 10 is similar to other extensional mode microresonators in that electrodes are disposed on selected ones of surfaces 12—15. The electrodes are connected to an alternating current source (not shown) to produce electric fields in the piezoelectric material, the directions of which are fixed by the position of the electrodes. Application of an electric field along the electric or X-axis produces stresses in the crystal along the mechanical or Y-axis so that the bar vibrates.

According to the embodiment of Figure 3, the X-axis is approximately aligned with the thickness direction. In either event, the Y-axis is aligned with the length direction. The resulting vibration consists of an expansion and contraction of the bar in its length direction.

Resonator 10 includes a suspension assembly 21 including two suspension arms 16 and 17 connected to sides 14 and 15, respectively, of bar 11. The ends of arms 16 and 17 opposite to the ends connected to bar 11 are connected to first ends of arms 18 and 19, respectively, the other ends of which are interconnected by means of an arm 20. Arms 18—20 form a frame. As clearly seen in Figure 1, arms 18 and 19 extend in spaced, parallel relationship, on opposite sides of bar 11, with arm 20 extending perpendicular to arms 18 and 19 and perpendicular to bar 11, adjacent one end thereof.

According to the present invention, piezoelectric microresonator 10 operates in the overtone or harmonic mode, specifically in the second overtone mode. That is, bar 11 includes an even number n of pairs of electrodes whereby bar 11 vibrates at a frequency $f=nf_o$ where $f_o$ is the frequency of bar 11 provided with a single pair of electrodes and n is an even integer. In the embodiment of Figure 1, n=2. Thus, microresonator 10 includes a first pair of electrodes 24 and 25 disposed on sides 14 and 15, respectively, of bar 11 and a second pair of electrodes 26 and 27 also disposed on sides 14 and 15, respectively, of bar 11. Electrodes 24 and 25 extend for a distance of less than half of the length of bar 11 and are positioned at one end of bar 11 whereas electrodes 26 and 27 have approximately the same length and are disposed adjacent the other end of bar 11.

As is well known in the art, electrodes 24—27 are formed by metallization and such metallization is preferably caused to slightly wrap around bar 11 so as to extend onto surfaces 12 and 13, as shown in Figure 2. This readily permits electrode 24 to be connected to electrode 27 by means of a metallization portion 28 on side 12 and for electrode 25 to be connected to electrode 26 by a similar metallization portion 29 on side 13. Metallizations 31 and 32 on the upper surfaces of arms 16 and 17, respectively, and 18 and 19, respectively, are connected to electrodes 26 and 27, respectively. This permits connection of electrodes 26, 25 and 27, 24 to pads 33 and 34, respectively, on arm 20 to which electrical leads may be bonded or otherwise connected for applying electrical signals to electrodes 24—27.

With electrodes 24—27 so situated, bar 11 will vibrate with respect to an even number of nodal lines and each pair of electrodes have their approximate centers aligned with such nodal lines. Arms 16 and 17 are then connected to sides 14 and 15 of bar 11 in such a manner as to contact the approximate centers of electrodes 26 and 27 where they will be approximately aligned with the nodal lines. Mounting arms 16 and 17 in alignment with the nodal lines maximizes the quality factor Q of bar 11.

The beforementioned U.S. Patent Nos. 4,216,402 and 4,139,793 discuss the possibility that piezoelectric microresonators operating in the extensional mode vibrate in a manner which is or may be the superposition of a principal extensional mode of oscillation, of a first shear-coupled mode of oscillation, and of a second extensional mode of oscillation. These patents discuss the possibility of connecting arms to the side of a bar so that a line connecting the suspension arms is at an acute angle to a line transverse to the bar. Such mounting is contemplated by the present invention, if desired.

The present invention also contemplates supporting bar 11 with arms located in positions other than the position shown for arms 16 and 17 in Figure 1. That is, additional arms 36 and 37 parallel to arms 16 and 17 could be connected between arms 18 and 19 and electrodes 24 and 25, respectively, as shown in phantom in Figure 1. Alternatively, arms 36 and 37 could be used and arms 16 and 17 omitted. Other alternatives are to use arms 17 and 36 only or arms 16 and 37 only. The use of arms 16 and 17 is the preferred embodiment according to the present invention.

It has been herein mentioned that electrodes 26 and 27 are "approximately" the same length as electrodes 24 and 25. In fact, because suspension arms 16 and 17 are not aligned with the longitudinal centerline of bar 11, bar 11 is not divided exactly in half and electrodes 26 and 27 are not

exactly the same length as electrodes 24 and 25. That is, because of the mounting, if the two halves of bar 11 were exactly equal in length, the frequency of vibration of the end including electrodes 26 and 27 would be slightly higher than the frequency of vibration of the other end because of the influence of arms 16 and 17. This being the case, the length of the end of bar 11 including electrodes 26 and 27 is made slightly longer than the length of the other end of bar 11. Since frequency is inversely proportional to length, this reduces the frequency of the end incorporating the suspension arms and increases the frequency of the other end so as to equalize the frequencies of the opposite ends.

Figure 1 shows the preferred location for electrodes 24—27. In this configuration, the X-axis of bar 11 is approximately aligned with the width direction w. Under some circumstances, it may be desirable to have the X-axis aligned with the thickness direction t. In this case, an electrode configuration as shown in Figure 3 would be used. In Figure 3, a first pair of electrodes 41 and 42 are deposited on sides 12 and 13, respectively, of bar 11, adjacent one end thereof, and a second pair of electrodes 43 and 44 are deposited on sides 12 and 13, respectively, adjacent the other end of bar 11. Electrode 42 is connected to electrode 43 by a metallization portion 45 deposited on side 14 and electrode 41 is connected to electrode 44 by a similar metallization portion deposited on side 15. Electrode 43 is connected to a metallization portion 47 on arm 17 and electrode 44 is connected to a metallization portion 48 on arm 16.

According to the present invention, there may be any even number n of pairs of electrodes whereby bar 11 will vibrate at an even multiple of the fundamental frequency thereof. Figure 4 shows an electrode configuration on bar 11 where bar 11 will operate at four times the fundamental frequency. According to the embodiment of Figure 4, each side 14 and 15 comprises four separate electrodes which are distributed over the length of the bar. Disposed on side 14 of bar 11 are spaced electrodes 51—54 and disposed on side 15 of bar 11 are spaced electrodes 55—58. Electrodes 55, 52, 57 and 54 are interconnected by means of metallization portions 59, 60 and 61 on side 12 and electrodes 51, 56, 53 and 58 are interconnected by means of similar metallization portions on side 13. Electrode 51 is connected to a metallization portion 62 on arm 16 and electrode 55 is connected to a metallization portion 63 on arm 17.

With the configuration of Figure 4, it is possible to connect arms 16 and 17 to bar 11 in a number of different locations. Arms 16 and 17 can be connected to the same pair of electrodes and any set of electrodes can be used. As discussed previously, arms 16 and 17 can be connected to the electrodes of different pairs. Connecting arms 16 and 17 to the same pair and preferably to the end pair is the preferred embodiment of the present invention.

The literature discusses various cuts of crystals which are possible for use in the extensional mode and it is beyond the scope of this specification to include a discussion of these various cuts. According to the embodiment of Figure 1, bar 11 is cut in a substantially Z-cut mode. According to the embodiment of Figure 3, bar 11 is cut in a substantially X-cut mode. With either configuration, a quartz resonator can be formed operating at 1.5 MHz with length L approximately equal to 3.65 mm which is a highly desirable length and frequency for use in micro-processor-based systems.

## Claims

1. A piezoelectric resonator for vibrating in the extensional mode, comprising a bar (11) and pairs of opposed electrodes (24—25, 26—27; 41—42, 43—44; 51—52—53—54, 55—56—57—58) disposed on side surfaces (14—15; 12—13) of said bar, there being an even number n of pairs of electrodes, whereby the bar vibrates at a frequency $f=nf_o$, where $f_o$ is the frequency of the bar provided with a single pair of electrodes and n is an even integer, and a suspension assembly (21) for said bar comprising a plurality of arms (16, 17) disposed to contact the bar at nodal points which are aligned with the approximate centers of certain of the electrodes, characterised in that the plurality of arms consists of two arms (16, 17) which contact the bar at the same nodal point, by further arms (18, 19, 20) connected to the free ends of the said two arms (16, 17), and in that the further arms (18, 19, 20) form a U-shaped frame.

2. A piezoelectric resonator according to claim 1, characterised in that the electrodes of each pair (e.g. 24, 25) are disposed parallel to each other and parallel to the length of the bar (11) and in that the pairs of electrodes (e.g. 24, 25 and 26, 27) are spaced along the length of the bar.

3. A piezoelectric resonator according to claim 1 or 2, characterised in that alternate pairs of electrodes are biased to create parallel, but oppositely directed electrical fields.

4. A piezoelectric resonator according to claim 3, characterised in that each electrode (e.g. 24) is connected to the opposite electrode (27) of the immediatley adjacent pair.

5. A piezoelectric resonator according to claim 1 or 2, characterised in that the bar (11) vibrates with respect to an even number of approximately transverse nodal lines, and in that the said two arms (16, 17) are connected to the bar at the location of one of these nodal lines.

6. A piezoelectric resonator according to any preceding claim, characterised in that the pairs of electrodes (e.g. 24, 25 and 26, 27) are disposed on opposite sides of the longitudinal centre of the bar (11), with no electrode at the centre.

7. A piezoelectric resonator according to any preceding claim, characterised in that the bar (11) and all arms (16—20) form a unitary microresonator structure etched from a piezoelectric crystal.

## Patentansprüche

1. Im Ausdehnungsmodus schwingender piezoelektrischer Resonator, mit einem Stab (11) und Paaren einander entgegengesetzter Elektroden (24—25, 26—27; 41—42, 43—44; 51—52—53—54, 55—56—57—58), die an Seitenflächen (14—15; 12—13) des Stabes angeordnet sind, wobei eine gerade Anzahl n von Elektrodenpaaren vorhanden ist, wodurch die Stange mit einer Frequenz $f=nf_o$ schwingt, wobei $f_o$ die Frequenz des mit einem einzigen Elektrodenpaar versehenen Stabes ist und n eine gerade ganze Zahl ist, und mit einer Aufhängungsanordnung (21) für den Stab, die eine Mehrzahl von Armen (16, 17) aufweist, die zum Berühren des Stabes an mit den ungefähren Zentren bestimmter Elektroden ausgerichteten Knotenpunkten angeordnet sind, dadurch gekennzeichnet, daß die Mehrzahl der Arme aus zwei Armen (16, 17) besteht, die den Stab an demselben Knotenpunkt berühren, daß weitere Arme (18, 19, 20) vorhanden sind, die mit den freien Enden der genannten beiden Arme (16, 17) verbunden sind, und daß die weiteren Arme (18, 19, 20) einen U-förmigen Rahmen bilden.

2. Piezoelektrischer Resonator nach Anspruch 1, dadurch gekennzeichnet, daß die Elektroden jedes Paares (z.B. 24, 25) parallel zueinander und parallel zu der Längserstreckung des Stabes (11) angeordnet sind, und daß die Paare von Elektroden (z.B. 24, 25 und 26, 27) entlang der Längserstreckung des Stabes voneinander beabstandet sind.

3. Piezoelektrischer Resonator nach Anspruch 1 oder 2, dadurch gekennzeichnet, daß aufeinander folgende Paare von Elektroden derart vorgespannt sind, daß sie zueinander parallel, jedoch entgegengesetzt gerichtete elektrische Felder erzeugen.

4. Piezoelektrischer Resonator nach Anspruch 3, dadurch gekennzeichnet, daß jede Elektrode (z.B. 24) mit der entgegengesetzten Elektrode (27) des unmittelbar benachbarten Paares verbunden ist.

5. Piezoelektrischer Resonator nach Anspruch 1 oder 2, dadurch gekennzeichnet, daß der Stab (11) in bezug auf eine gerade Anzahl ungefähr transversaler Knotenlinien schwingt, und daß die genannten beiden Arme (16, 17) an dem Ort einer dieser Knotenlinien mit dem Stab verbunden sind.

6. Piezoelektrischer Resonator nach einem der vorausgehenden Ansprüche, dadurch gekennzeichnet, daß die Paare von Elektroden (z.B. 24, 25 und 26, 27) auf einander gegenüberliegenden Seiten der Längsmitte des Stabes (11) angeordnet sind, wobei an der Längsmitte keine Elektrode vorhanden ist.

7. Piezoelektrischer Resonator nach einem der vorausgehenden Ansprüche, dadurch gekennzeichnet, daß der Stab (11) und alle Arme (16 bis 20) eine als Einheit ausgebildete Mikroresonatorkonstruktion bilden, die aus einem piezoelektrischen Kristall geätzt ist.

**Revendications**

1. Résonateur piézo-électrique destiné à vibrer en mode d'extension, comprenant une barre (11) et une paire d'électrodes opposées (24—25, 26—27; 41—42, 43—44; 51—52—53—54, 55—56—57—58) disposées sur des surfaces latérales (14—15; 12—13) de cette barre, le nombre n de paires d'électrodes étant pair de sorte que la barre vibre à une fréquence $f=nf_o$ où $f_o$ est la fréquence de la barre munie d'une seule paire d'électrodes et où n est un nombre entier pair, et un ensemble de suspension (21) de cette barre comprenant un certain nombre de bras (16, 17) disposés de manière à venir en contact avec la barre aux points nodaux qui sont alignés avec les centres approximatifs de certaines des électrodes, résonateur caractérisé en ce que les différents bras consistent aux deux bras (16, 17) en contact avec la barre au même point nodal, et en des bras supplémentaires (18, 19, 20) reliés aux extrémités libres des deux bras (16, 17) et en ce que les bras supplémentaires (18, 19, 20) forment un chassis en U.

2. Résonateur piézo-électrique selon la revendication 1, caractérisé en ce que les électrodes de chaque paire (par exemple 24, 24) sont disposées parallèlement l'une à l'autre et parallèlement à la longueur de la barre (11), et en ce que les paires d'électrodes (par exemple 24, 25 et 26, 27) sont espacées suivant la longueur de la barre.

3. Résonateur piézo-électrique selon l'une quelconque des revendications 1 et 2, caractérisé en ce que des paires d'électrodes alternées sont polarisées pour créer des champs électriques parallèles mais dirigés en opposition.

4. Résonateur piézo-électrique selon la revendication 3, caractérisé en ce que chaque électrode (par exemple 24) est reliée à l'électrode opposée (27) de la paire immédiatement adjacente.

5. Résonateur piézo-électrique selon l'une quelconque des revendications 1 et 2, caractérisé en ce que la barre (11) vibre par rapport à un nombre pair de lignes nodales approximativement transversales et en ce que les deux bras (16, 17) sont reliés à la barre à l'endroit de l'une de ces lignes nodales.

6. Résonateur piézo-électrique selon l'une quelconque des revendications précédentes, caractérisé en ce que les paires d'électrodes (par exemple 24, 25 et 26, 27) sont disposées sur les côtés opposés du centre longitudinal de la barre (11), sans électrode au centre.

7. Résonateur piézo-électrique selon l'une quelconque des revendications précédentes, caractérisé en ce que la barre (11) et tous les bras (16 à 20) forment une structure de microrésonateur unitaire gravée à partir d'un cristal piézo-électrique.

FIG. 1.

FIG. 2.

FIG. 3.

FIG. 4.